# EUROPEAN PATENT APPLICATION

(11) **EP 4 567 517 A1**
(43) Date of publication of application: **11.06.2025**
(21) Application number: 23214792.6
(22) Date of filing: 07.12.2023
(51) Int. Cl.: G03F 7/20

(54) **METROLOGY TOOL AND METHOD WITH RECEIVING SCATTERED RADIATION IN A PLURALITY OF DISCRETE TIME INTERVALS**

(71) Applicant: ASML Netherlands B.V., 5500 AH Veldhoven (NL)
(72) Inventor: KUZUCU, Oktay, Onur, 5500 AH Veldhoven (NL)
(74) Representative: ASML Netherlands B.V.

(57) **Abstract**

A metrology tool for inspection of a structure on an object comprises: projection optics; detection optics; a detector array; and a controller. The projection optics is arranged to project radiation onto the structure and the detection optics is arranged to receive radiation scattered by the structure. The detector array comprises a plurality of detector elements. The controller is operable to: control the detector array so as to determine at least one image; and determine one or more parameters of interest in dependence on the at least one determined image. The controller is configurable such that each pixel of at least one determined image is indicative of a total dose of radiation received by one of detector elements in a plurality of discrete time intervals during a measurement time interval, the pixel value being read out from the corresponding detector element at the end of the measurement time interval.

## Description

### FIELD

The present invention relates to metrology tool for determining one or more parameters of interest of a structure on an object. In particular, it relates to such a metrology tool comprising a detector array (e.g. a camera). The present invention also relates to a corresponding metrology method for determining one or more parameters of interest of a structure on an object. The metrology tool may comprise a scatterometer. The metrology tool may have particular application in the field of lithography. The object may be a substrate, for example a resist-coated silicon wafer.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In general, metrology tools may be used to inspect or qualify substrates (e.g. wafers). The metrology tool may comprise a scatterometer. The object may be a substrate, for example a resist-coated silicon wafer. Such a substrate may comprise a plurality of structures (also referred to as targets) that it may be desired to measure. The one or more parameters may comprise one or more of the following: the overlay of two misaligned gratings or periodic structures on the object; and/or a reconstructed structure or profile giving rise to a determined scattering spectrum.

It may be desirable to provide new metrology tools, and associated methods, which at least partially address one or more problems associated with known arrangements, whether such problems are discussed herein or otherwise.

### SUMMARY

According to a first aspect of the present disclosure there is provided a metrology tool for determining one or more parameters of interest of a structure on an object, the metrology tool comprising: projection optics arranged to project radiation onto the structure; detection optics arranged to receive at least a portion of radiation scattered by the structure; a detector array comprising a plurality of detector elements, each of the plurality of detector elements being operable to determine a dose of received scattered radiation; and a controller operable to: control the detector array so as to determine at least one image, each such at least one image comprising a plurality of doses of scattered radiation, each determined by a different one of the plurality of detector elements; and determine one or more parameters of interest in dependence on the at least one determined image; and wherein the controller is configurable such that each dose of scattered radiation of at least one of the at least one determined image comprises a total dose of radiation received by a corresponding one of the plurality of detector element in a plurality of discrete time intervals during a measurement time interval, which is read out from the corresponding detector element at the end of the measurement time interval.

The metrology tool may comprise a scatterometer. The object may be a substrate, for example a resist-coated silicon wafer. Such a substrate may comprise a plurality of structures (also referred to as targets) that it may be desired to measure. The one or more parameters may comprise one or more of the following: the overlay of two misaligned gratings or periodic structures on the object; and/or a reconstructed structure or profile giving rise to a determined scattering spectrum.

The detector array may be referred to as a camera. Each of the plurality of detector elements, or a measurement made thereby, may alternatively be referred to as a pixel. The detector array may comprise a two-dimensional array of detector elements.

When performing lithographic processes it is desirable to make frequent measurements of the structures created, for example, for process control and verification. Tools to make such measurement are typically called metrology tools. Many existing metrology tools involve the measurement of a plurality of images (each one, for example, comprising a plurality of doses of radiation) captured with a camera. For example, some metrology tools make overlay measurements, which exploit the fact that the diffraction efficiencies of periodic structures are dependent on the unit cell of the periodic structure (and, therefore, any asymmetry of the unit cell). The response of such measurements is sensitive to the wavelength of radiation used by the scatterometer. Furthermore, it is desirable to separate out any imbalance in the relative intensities of certain diffraction orders that is due to overlay errors and other sources of such imbalances. For this reason, these scatterometry metrology tools often make a plurality of separate, sequential measurements of images with different wavelengths of radiation, which are then combined. The specific wavelengths (and bandwidths) are typically dependent on the specific lithographic process or recipe and are typically optimized for a given process so as to maximize the response to overlay errors.

It will be appreciated that as used herein a dose of radiation is intended to mean a quantity of energy received from the radiation. It will also be appreciated that, in general, a dose of energy received by a detector element from radiation may be a time integral of the power of the radiation during a measurement time. If a detector array having a given dynamic range measures two or more different radiation beams having different powers, the smaller power radiation beam may be measured for a larger measurement time and the larger power radiation beam may be measured for a smaller measurement time.

In one type of metrology tool, a broadband radiation source is used and from this a plurality of different wavelengths are selected. The initial source intensity, optical transmission and camera quantum efficiency of each of the plurality of different wavelengths can vary significantly. In order for all of the different wavelengths to be measured by a single detector array, in the dynamic range of the camera, typically a different exposure time is used for each different wavelength. However, it has been found that for some wavelengths, the required exposure times can be so short (for example < 1 ms) that they can give rise to reproducibility issues. At present, for such wavelengths, a neutral density filter is used to attenuate the input illumination of such wavelengths in order to increase the exposure times to reasonable levels (for example > 1 ms). However, the same neutral density filter would penalize the other wavelengths with lower brightness and/or efficiency. This would potentially make the exposure times for these other wavelengths impractically long, significantly decreasing throughput. Therefore, in order to maintain reasonable throughput of the metrology tool, the neutral density filter may need to be moved into and out of the beam path, when switching between wavelengths, which also consumes a significant time (of the order of seconds). It is therefore not practical to perform this switch between each two sequential targets on the substrate (wafer). As a result, the substrate (wafer) is sometimes measured twice (or more if necessary): a first time using one wavelength and a neutral density filter and a second time using another wavelength and no filter.

The metrology tool according to the first aspect is advantageous, as now discussed.

Advantageously, since the controller is configurable such that each dose of scattered radiation of the at least one determined image comprises a total dose of radiation received by a corresponding detector element in a plurality of discrete time intervals during a measurement time interval, which is read out from the corresponding detector element at the end of the measurement time interval, the metrology tool according to the first aspect effectively uses the detector array to attenuate the radiation for that determined dose. Effectively, the metrology tool according to the first aspect is operable to use a technique that may be referred to as multiple exposure in one frame. Advantageously, with such an interleaved exposure, the sampling at a plurality of discrete time intervals results in a better averaging performance over system-induced dynamic effects (such as, for example, vibrations, mechanical resonances and so on within the metrology tool). An alternative to using the detector array to effectively attenuate the radiation would be to modulate the output of the radiation source. A second advantage of using the detector array to effectively attenuate the radiation is to prevent any wavelength change that might arise from such modulation of the radiation source.

Note that, as explained above, the controller is effectively operable to use a technique that may be referred to as multiple exposure in one frame. With such a technique, a single image is read out from the detector array once for the at least one determined image. This is different from determining a plurality of images that are subsequently combined (which may be referred to simply as multiple exposure). That is, the metrology tool according to the first aspect does not determine a plurality of images that are read out from the detector array and stored (for example temporarily) and then subsequently combined. Rather, the at least one determined image determined by the metrology tool according to the first aspect is a single image, each pixel of which comprises a total dose of radiation received by the plurality of detector elements of the detector array in a plurality of discrete time intervals during a measurement time interval is read out by each detector element at the end of the measurement time interval. That is, this image is read out once. This is significant as the process of reading out a detector array (for example a plurality of detector elements or pixels in a CMOS array) takes some time. Therefore, the use of multiple exposure in one frame (with one read out process at the end of the measurement time interval) can be significantly quicker than multiple exposure processes (where each dose or sub-dose is read out individually).

Each of the plurality of detector elements may comprise: a photosensitive element; and a plurality of switches. The photosensitive element and the plurality of switches may be arranged such that: (a) during each of the plurality of discrete time intervals of that detector element, an amount of charge at a first node of the detector element is changed by an amount that is dependent on an amount of radiation received by the photosensitive element; (b) at the end of each of the plurality of discrete time intervals an amount of charge that is dependent on an amount of radiation received by the photosensitive element during that discrete time interval is transferred from the first node to a second node; and (c) at the end of the measurement time interval a signal indicative of the accumulated charge at the second node is output by the detector element.

Such an arrangement is particularly suitable for determining a dose that comprises a total dose of radiation received by each of the detector elements in a plurality of discrete time intervals during a measurement time interval.

The plurality of switches may comprise a first reset switch. The first node may be disposed between a cathode of the photosensitive element and the first reset switch. The controller may be configured to control the first reset switch at the start of each of the plurality of discrete time intervals so as provide a first bias or voltage to the first node.

For example, the first reset switch may be a transistor. The source of the transistor may be connected to a first voltage. The drain of the transistor may be connected to the first node. The controller may be operable to open and close the first reset switch by applying a signal to the gate of the transistor. Opening the switch in this way may reverse bias the photosensitive element (for example a photodiode) to the first voltage. A second terminal of the photosensitive element may be connected to earth.

The metrology tool may further comprise a capacitor and the plurality of switches may comprise a second reset switch. The second node may be disposed between the capacitor and the second reset switch. The controller may be configured to control the second reset switch at the start of the measurement time interval so as provide a second bias or voltage to the second node.

For example, the second reset switch may be a transistor. The source of the transistor may be connected to a second voltage. The drain of the transistor may be connected to the second node. The controller may be operable to open and close the second reset switch by applying a signal to the gate of the transistor. Opening the switch in this way may bias one terminal of the capacitor to the second voltage. A second terminal of the capacitor may be connected to earth. The capacitor may have a larger capacitance than the photosensitive element.

The plurality of switches may comprise a transfer switch disposed between the first node and the second node. The controller may be configured to control the transfer switch at the end of each of the plurality of discrete time intervals so as to transfer the amount of charge that is dependent on an amount of radiation received by the photosensitive element during that discrete time interval from the first node to a second node.

For example, the transfer switch may be a transistor. The source and drain of the transistor may be connected to the first and second nodes. The controller may be operable to open and close the transfer switch by applying a signal to the gate of the transistor.

The plurality of switches may comprise a read-out switch. The controller may be configured to control the read-out switch at the end of the measurement time interval so as to output the signal indicative of the accumulated charge at the second node.

For example, the read-out switch may be a transistor. The source of the transistor may be connected to the second node. The source of the transistor may be connected to an output node or line. The controller may be operable to open and close the transfer switch by applying a signal to the gate of the transistor. The read-out switch may alternatively be referred to as a row select switch. The controller may be operable to use the read-out switch to sequentially connect the second node of a plurality of detector elements from different rows of the detector array to an output or column line.

In some embodiments, the or each detector element may comprise a pixel of a CMOS (complementary metal-oxide-semiconductor) sensor pixel.

Each of the plurality of detector elements may further comprise an amplifier arranged to amplify the output signal. The amplifier may be disposed between the second node and the read-out switch. For example, the amplifier may comprise a transistor. The transistor may be used as a source follower (also known as common-drain). The source of the transistor may be connected to a reference voltage. The gate of the transistor may be connected to the second node. The source of the transistor may be connected to the read-out switch.

The detector may comprise an active-pixel sensor.

In some embodiments the detector may comprise a CMOS (complementary metal-oxide-semiconductor) sensor.

When determining the at least one of the at least one determined image the controller may be operable to send a control signal to the detector and the number of and/or the length of the plurality of discrete time intervals may be dependent on the control signal.

The control signal may be used to control the detector array. For example, the control signal may comprise a pulse train, each pulse corresponding to a different one of the plurality of discrete time intervals.

The controller may be operable to generate the control signal.

For example, for embodiments wherein the plurality of discrete time intervals have uneven temporal spacings and/or unequal durations, the controller may be operable to generate a pulse train. For example, the controller may comprise, or have access to, a random or quasi-random number generator.

The controller may be operable to generate the control signal so as to achieve a target ratio of a total integrated duration of the plurality of discrete time intervals to the measurement time interval.

That is, the controller is operable to generate the control signal so as to achieve a target attenuation factor.

The controller may be operable to generate the control signal in dependence on: (a) a power of the radiation that contributes to that image; (b) a dynamic range of the detector elements measuring the plurality of doses; and (c) a measurement time interval threshold.

It will be appreciated that the target attenuation factor will, in general, be dependent on: (a) the power of the radiation that contributes to that image; (b) the dynamic range of the detector elements measuring the plurality of dose (which the image comprises); and (c) a measurement time interval threshold. Furthermore, in turn, the measurement time interval threshold may be dependent on a characteristic time scale of the system-induced dynamic effects. The power of the radiation that contributes to that image may be known or measured. The dynamic range of the detector elements measuring the image may be known. The measurement time interval threshold may be sufficiently large that a measurement over such a time period would average out such system-induced dynamic effects. The measurement time interval threshold may, for example, be of the order of 1 ms.

For example, from the power of the radiation that contributes to that image and the dynamic range of the detector array measuring the image, a target sampling time may be generated that ensures that the doses of radiation received by the detector elements are within the dynamic range of the detector elements. If the target sampling time is above the measurement time interval threshold then the detector array may be not used for attenuation of the radiation. In contrast, if the target sampling time is below the measurement time interval threshold then a target attenuation factor may be determined. The target attenuation factor may be determined to be equal to or greater than a ratio of the measurement time interval threshold to the target sampling time.

The controller may be operable to: control the detector array so as to determine at least two images, each such at least two images comprising a plurality of doses of scattered radiation; and determine the one or more parameters of interest in dependence on the at least two determined images.

In some embodiments, each dose of scattered radiation of at least one of the at least two images comprises a total dose of radiation received by a corresponding one of the plurality of detector elements in a plurality of discrete time intervals during a measurement time interval, which is read out from the corresponding detector element at the end of the measurement time interval; and each dose of scattered radiation of at least one of the at least two images comprises a dose of radiation received during a continuous measurement time interval, which is read out from the corresponding detector element at the end of the measurement time interval. Advantageously, such embodiments use the detector array, controlled by the controller, to effectively attenuate one dose while the other dose is not attenuated.

Alternatively, in some other embodiments, each dose of scattered radiation of at least two of the at least two images comprises a total dose of radiation received by a corresponding one of the plurality of detector elements of the detector array in a plurality of discrete time intervals during a measurement time interval, which is read out from the corresponding detector element at the end of the measurement time interval but a ratio of the total integrated duration of the plurality of discrete time intervals to the measurement time interval is different for the at least two images. Such embodiments use the detector array, controlled by the controller, to effectively attenuate the radiation used for forming the at least two images by different amounts.

The at least two images may be determined sequentially by projecting different radiation onto the structure.

Each of the at least two images may be determined using scattered radiation having different wavelengths.

The at least two images may be determined at substantially the same time by projecting a single radiation beam onto the structure.

It will be appreciated that as used here, two images being determined at substantially the same time is intended to mean that there is at least some temporal overlap between the two measurements.

The at least two images may be determined using a different set of the plurality of detecting elements of the detector array.

The plurality of discrete time intervals may have any temporal spacings and/or durations as desired or required. For example, the plurality of discrete time intervals could be periodic and may have equal durations.

The plurality of discrete time intervals may be not equally spaced within the measurement time interval.

The plurality of discrete time intervals may be not all of equal duration.

There may be significant advantage to such embodiments wherein the plurality of discrete time intervals the have uneven temporal spacings and/or durations. Recall that one advantage of the sampling obtained by the measurement(s) over a plurality of discrete time intervals is that this results in a better averaging performance over system-induced dynamic effects (such as, for example, vibrations, mechanical resonances and so on within the metrology tool). However, if the sampling achieved over the plurality of discrete time intervals is periodic and happens to have a frequency at, or close to, a frequency of a significant component of the system-induced dynamic effects then no, or little, averaging of those components will be achieved. In contrast, by using a plurality of discrete time intervals the having uneven temporal spacings and/or durations, in general, a better averaging of the system-induced dynamic effects will be achieved.

The plurality of discrete time intervals may be randomly or quasi-randomly spaced and/or may have random or quasi-random durations.

A total integrated duration of the plurality of discrete time intervals may be less than the measurement time interval by at least a factor of 5.

With such embodiments, the detector array is operable, under the control of the controller, to achieve an effective attenuation of the radiation by at least a factor of 5.

The total integrated duration of the plurality of discrete time intervals may be less than the measurement time interval by at least a factor of 10. The total integrated duration of the plurality of discrete time intervals may be less than the measurement time interval by at least a factor of 20.

The measurement time interval may be 1 ms or more.

The metrology tool may further comprise a radiation source operable to produce the radiation.

The radiation source may be a broadband radiation source. For example, the radiation source may be operable to produce radiation with a spectrum of around 400-900 nm.

The metrology tool may further comprise a radiation adjustment module operable to receive radiation from the radiation source and to output radiation having modified characteristics.

The characteristics may comprise wavelength, bandwidth, polarization state etc. The radiation adjustment module may be adjustable so that the characteristics of the output radiation can be controlled.

The metrology tool may further comprise a support for supporting an object such that it is positionable in an illumination region of the projection optics.

The projection optics is configured to project radiation onto the structure when disposed in the illumination region. The support for supporting a substrate may comprise a substrate holder operable to secure the substrate. For example, the support may comprise a clamp for clamping the substrate to the support. The support may comprise a stage such as a wafer stage.

The metrology tool may further comprise a movement mechanism operable to cause relative movement of the support and the illumination region of the projection optics.

This may allow the object or substrate to be stepped or scanned through the illumination region. As used herein scanning of an object is intended to mean continuous movement of the object. As used herein stepping of an object is intended to mean movement of the object in a plurality of successive (temporally separated) steps.

According to a second aspect of the present disclosure there is provided a metrology method for determining one or more parameters of interest of a structure on an object, the metrology method comprising: projecting radiation onto the structure; receiving at least a portion of the radiation scattered by the structure; determining at least one image, each such at least one image comprising a plurality of doses of scattered radiation; and determining one or more parameters of interest from the at least one determined image; wherein each dose of scattered radiation of at least one of the at least one determined images comprises a total dose of radiation received by a corresponding detector element in a plurality of discrete time intervals during a measurement time interval, which is read out from the corresponding detector element at the end of the measurement time interval.

The method according to the second aspect may use the metrology tool according to the first aspect. The method according to the second aspect may comprise any combination of the features of the metrology tool according to the first aspect as appropriate.

Advantageously, since each dose of scattered radiation of the at least one of the at least one determined images comprises a total dose of radiation received by the corresponding detector element in a plurality of discrete time intervals during a measurement time interval, which is read out by the corresponding detector element at the end of the measurement time interval, the metrology method according to the second aspect effectively uses a detector array to attenuate the radiation for that determined dose. Effectively, the metrology method according to the second aspect is operable to use a technique that may be referred to as multiple exposure in one frame. Advantageously, with such an interleaved exposure, the sampling at a plurality of discrete time intervals results in a better averaging performance over system-induced dynamic effects (such as, for example, vibrations, mechanical resonances and so on within the metrology tool). A second advantage of using a detector to effectively attenuate the radiation is to prevent any wavelength change that might arise from modulating the radiation source.

Determining each dose of scattered radiation of the at least one of the at least one determined images may comprise: (a) changing a charge at a first node of the detector element during each of the plurality of discrete time intervals of that detector element by an amount that is dependent on an amount of radiation received by the detector element; (b) at the end of each of the plurality of discrete time intervals transferring an amount of charge that is dependent on an amount of radiation received by the detector element during that discrete time interval from the first node to a second node; and (c) at the end of the measurement time interval outputting a signal indicative of the accumulated charge at the second node.

With such an arrangement, the information about the amount of radiation received during the plurality of discrete time intervals during a measurement time interval is effectively buffered and stored locally on the detector element (pixel) as an amount of charge. Advantageously, this is significantly quicker than reading out a signal indicative of the amount of radiation received during each of the plurality of discrete time intervals, storing this (e.g. in memory) and then combining these amounts to determine the total dose. This is partially due the large amount of time required to read out the plurality of detector elements (pixels) of a detector array.

The method may comprise setting the first node to a first bias or voltage at the start of each of the plurality of discrete time intervals.

The method may comprise setting the second node to a second bias or voltage at the start of the measurement time interval.

Determining the at least one of the at least one determined images may comprise sending a control signal to a detector array and the number of and/or the length of the plurality of discrete time intervals may be dependent on the control signal.

The control signal may be used to control the detector array. For example, the control signal may comprise a pulse train, each pulse corresponding to a different one of the plurality of discrete time intervals.

The metrology method may further comprise generating the control signal.

The control signal may be generated so as to achieve a target ratio of a total integrated duration of the plurality of discrete time intervals to the measurement time interval.

That is, the method may generate the control signal so as to achieve a target attenuation factor.

The control signal may be generated in dependence on: (a) a power of the radiation that contributes to that image; (b) a dynamic range of the detector array measuring the plurality of doses; and (c) a measurement time interval threshold.

It will be appreciated that the target attenuation factor will, in general, be dependent on: (a) the power of the radiation that contributes to that image; (b) the dynamic range of the detector measuring the plurality of doses (that the image comprises); and (c) a measurement time interval threshold. Furthermore, in turn, the measurement time interval threshold is dependent on a characteristic time scale of the system-induced dynamic effects. The power of the radiation that contributes to that image may be known or measured. The dynamic range of the detector array measuring the plurality of doses may be known. The measurement time interval threshold may be sufficiently large that a measurement over such a time period would average out such system-induced dynamic effects. The measurement time interval threshold may, for example, be of the order of 1 ms.

For example, from the power of the radiation that contributes to that image and the dynamic range of the detector array measuring the plurality of doses, a target sampling time may be generated that ensures that the doses of radiation received by the detector elements are within the dynamic range of the detector array. If the target sampling time is above the measurement time interval threshold then the detector array may not be used for attenuation of the radiation. In contrast, if the target sampling time is below the measurement time interval threshold then a target attenuation factor may be determined. The target attenuation factor may be determined to be equal to or greater than a ratio of the measurement time interval threshold to the target sampling time.

The metrology method may comprise determining at least two images, each such at least one image comprising a plurality of doses of scattered radiation, from which one or more parameters of interest are determined.

In some embodiments, the detector array may be used to effectively attenuate radiation when determining one or more images while radiation is not so attenuated.

In some other embodiments, the detector array may be used to effectively attenuate radiation when determining a plurality of images. For such embodiments, in general, the radiation used for the plurality of determined images may be attenuated by different factors.

The at least two images may be determined sequentially by projecting different radiation onto the structure.

Each of the at least two images may be determined using radiation having different wavelengths.

The at least two images may be determined at substantially the same time by projecting a single radiation beam onto the structure.

It will be appreciated that as used here, two images of scattered radiation being determined at substantially the same time is intended to mean that there is at least some temporal overlap between the two measurements. For example, the measurement time intervals of the two measurements may, in general, be different.

Each of the at least two doses of scattered radiation may be determined by a different set of detector elements.

The plurality of discrete time intervals may have any temporal spacings and/or durations as desired or required. For example, the plurality of discrete time intervals could be periodic and may have equal durations.

The plurality of discrete time intervals may be not equally spaced within the measurement time interval.

The plurality of discrete time intervals may be not all of equal duration.

As explained above (with reference to the apparatus according to the first aspect), by using a plurality of discrete time intervals the having uneven temporal spacings and/or durations, in general, a better averaging of the system-induced dynamic effects will be achieved.

The plurality of discrete time intervals may be randomly or quasi-randomly spaced and/or may have random or quasi-random durations.

A total integrated duration of the plurality of discrete time intervals may be less than the measurement time interval by at least a factor of 5.

With such embodiments, the detector is operable, under the control of the controller, to achieve an effective attenuation of the radiation by at least a factor of 5.

The total integrated duration of the plurality of discrete time intervals may be less than the measurement time interval by at least a factor of 10. The total integrated duration of the plurality of discrete time intervals may be less than the measurement time interval by at least a factor of 20.

The measurement time interval may be 1 ms or more.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 is a schematic illustration of a metrology apparatus, such as a scatterometer, comprising a radiation projector and a spectrometer detector;
- Figures 5(a), 5(b), 5(c) and 5(d) comprise (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures;
- Figure 6 is a schematic illustration of an example new metrology tool for determining one or more parameters of interest of a structure on an object (e.g. a wafer) according to an embodiment of the present disclosure;
- Figure 7 shows a circuit diagram for a detector element, which may be used for each of the detector elements of the detector array shown in Figure 6;
- Figure 8(a) shows an example pulse train that is representative of a temporal sampling by one of the detector elements shown in Figure 7, the pulse train comprising a plurality of pulses, each of which represents one of a plurality of discrete time intervals during a measurement time interval;
- Figure 8(b) shows an example control signal that may be provided by the controller to the gate of the first reset switch of Figure 7;
- Figure 8(c) shows an example control signal that may be provided by the controller to the gate of the second reset switch of Figure 7;
- Figure 8(d) shows an example control signal that may be provided by the controller to the gate of the transfer switch of Figure 7;
- Figure 8(e) shows an example control signal that may be provided by the controller to the gate of the read-out switch of Figure 7;
- Figure 9 is a schematic illustration of a new metrology method according to an embodiment of the present disclosure, which may, for example, be carried out using the new metrology tool shown in Figures 6 and 7; and
- Figure 10 shows an example flow chart for determining (at step 430) each dose of scattered radiation (i.e. each pixel) of the at least one determined images that is attenuated by the detector array as part of the method shown in Figure 9.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

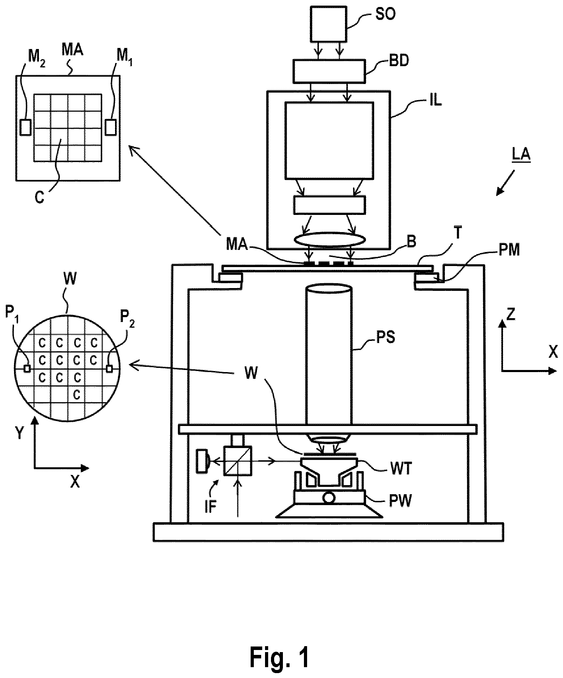

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

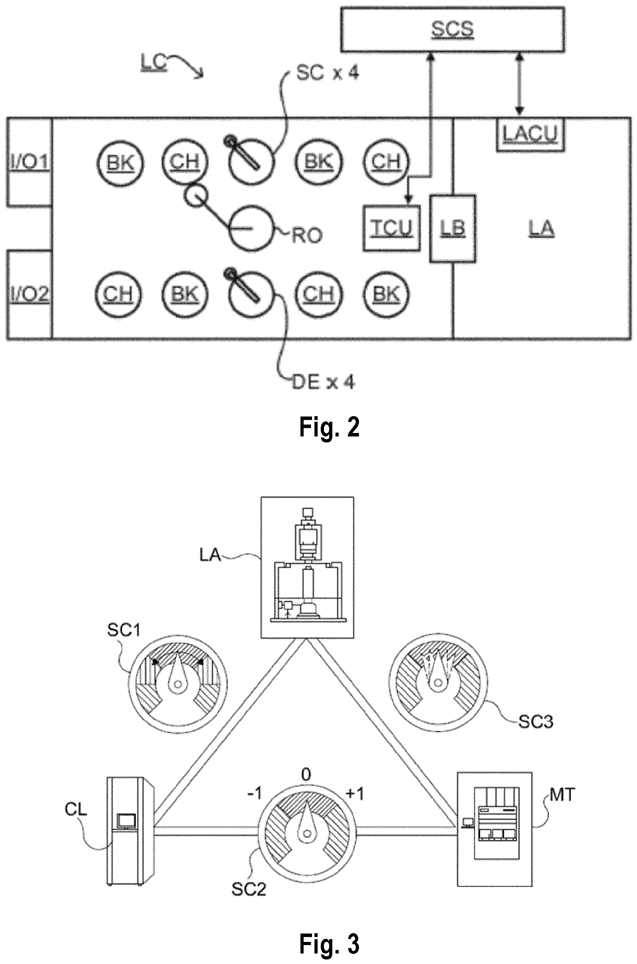

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization state. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similarly to the functional part of the design layout such that the overall process parameter measurements better resembles the functional part of the design layout. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1, each of which is incorporated herein by reference in its entirety.

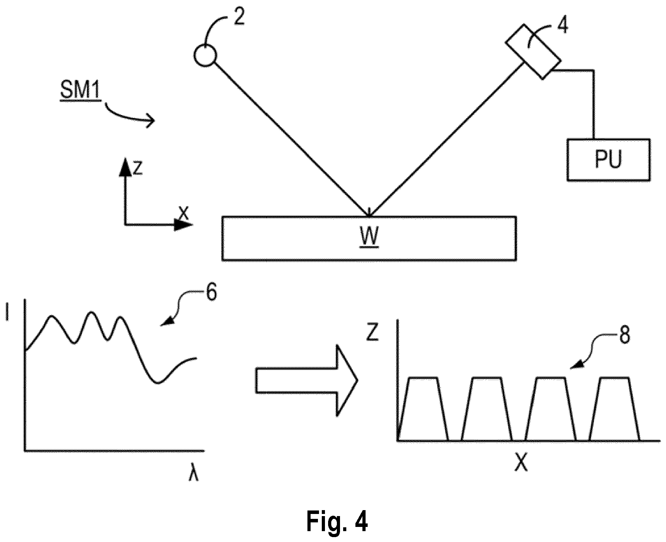

A metrology apparatus, such as a scatterometer, is depicted in Figure 4. It comprises a broadband (white light) radiation projector 2 which projects radiation onto a substrate W. The reflected or scattered radiation is passed to a spectrometer detector 4, which measures a spectrum 6 (i.e. a measurement of intensity as a function of wavelength) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer. Although the schematic scatterometer depicted in Figure 4 comprises a broadband (white light) radiation projector 2 other scatterometers may alternatively use band-limited or narrowband radiation.

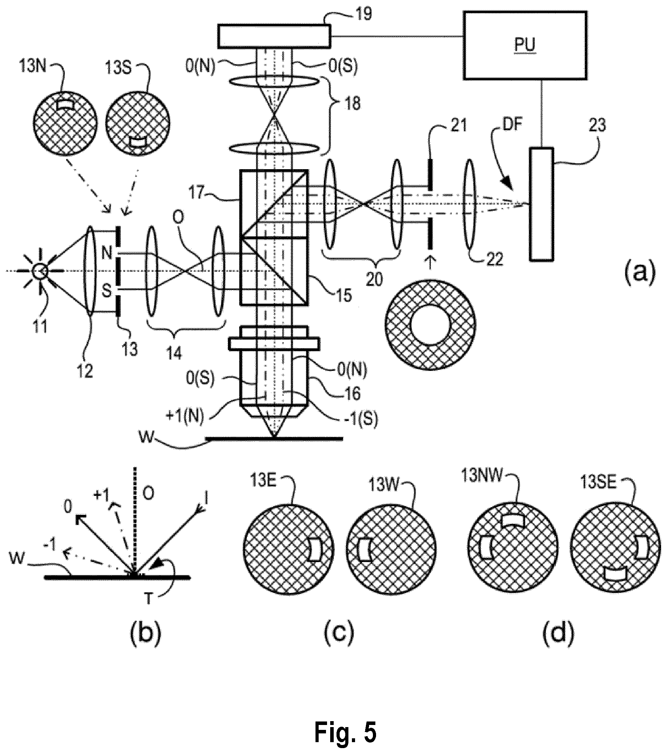

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 5(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled -1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

Some embodiments of the present disclosure relate to a new metrology tool for determining one or more parameters of interest of a structure on an object (e.g. a wafer). In particular, they relate to a new metrology tool comprising a detector array comprising a plurality of detector elements (pixels) wherein the detector array is arranged to provide fast, controllable attenuation to radiation received by it in order to ensure that both: (a) the amount of radiation used to form an image is within the dynamic range of the detector array; and (b) the measurement time period over which the image is captured is not undesirably short.

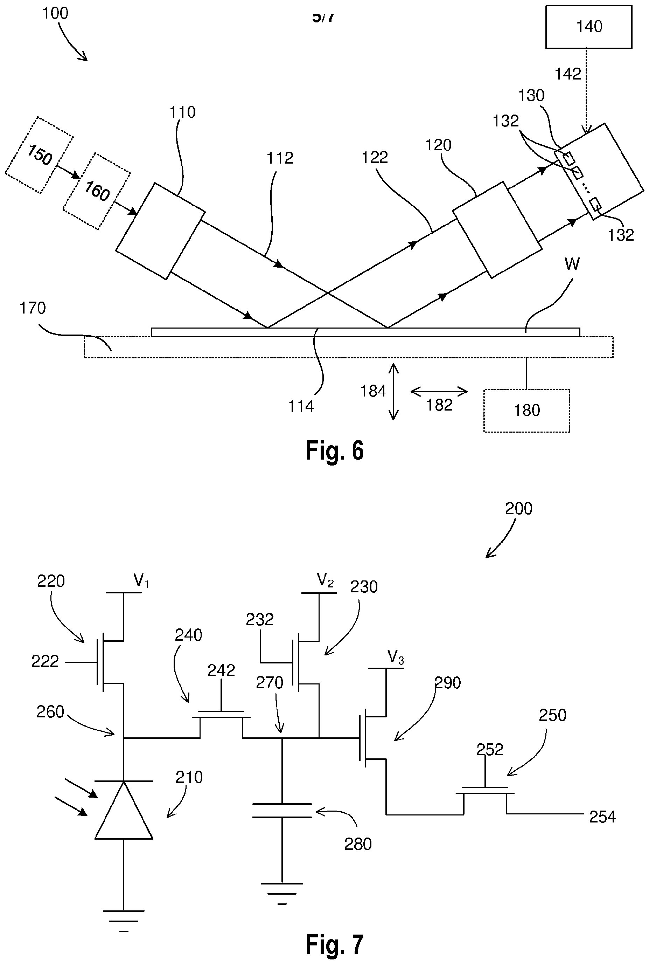

An example of such a new metrology tool is now described with reference to Figure 6.

Figure 6 is a schematic illustration of an example new metrology tool 100 for determining one or more parameters of interest of a structure on an object. The metrology tool 100 comprises: projection optics 110; detection optics 120; a detector array 130; and a controller 140.

The projection optics 110 is arranged to project radiation 112 onto the structure. In particular, the projection optics 110 is arranged to project radiation 112 onto an illumination region 114 (or field of view) in which an object, such as a substrate W, on which the structure is defined is positionable.

The detection optics 120 is arranged to receive at least a portion of radiation 122 scattered by the structure.

The detector array 130 comprises a plurality of detector elements 132. For example, the detector array 130 may comprise a two-dimensional array of detector elements 132. Each of the plurality of detector elements 132 is operable to determine a dose of a portion of received scattered radiation 122. The detector array 130 may be referred to as a camera. Each of the plurality of detector elements 132, or a measurement made thereby, may alternatively be referred to as a pixel.

The controller 140 is operable to control the detector array 130 so as to determine at least one image, each such at least one image comprising a plurality of doses of scattered radiation, each determined by a different one of the plurality of detector elements 132. The controller 140 is further operable to determine one or more parameters of interest in dependence on the at least one determined image.

The controller 140 is configurable such that each dose of scattered radiation of at least one of the at least one determined image comprises a total dose of radiation received by a corresponding one of the plurality of detector elements 132 in a plurality of discrete time intervals during a measurement time interval, which is read out from the corresponding detector element at the end of the measurement time interval.

Optionally, the metrology tool 100 may further comprising a radiation source 150 operable to produce the radiation 112 projected onto the illumination region 114 by the projection optics 110. The radiation source 150 may be a broadband radiation source. For example, the radiation source 150 may be operable to produce radiation with a spectrum of around 400-900 nm.

Optionally, the metrology tool 100 may further comprise a radiation adjustment module 160 operable to receive radiation from the radiation source 150 and to output radiation having modified characteristics. The characteristics may comprise wavelength, bandwidth, polarization state etc. The radiation adjustment module 160 may be adjustable so that the characteristics of the output radiation 112 can be controlled.

Optionally, the metrology tool 100 may further comprise a support 170 for supporting an object W such that it is positionable in an illumination region 114 of the projection optics. The projection optics 10 is configured to project radiation onto the structure when disposed in the illumination region 114. The support 170 for supporting a substrate W may comprise a substrate holder operable to secure the substrate W. For example, the support 170 may comprise a clamp for clamping the substrate W to the support 170. The support 170 may comprise a stage such as a wafer stage.

Optionally, the metrology tool may further comprise a movement mechanism 180 operable to cause relative movement of the support 170 and the illumination region 114 of the projection optics 110. Such movement is indicated schematically in Figure 6 by arrows 182, 184. This may allow the object or substrate W to be stepped or scanned through the illumination region 114. As used herein scanning of an object is intended to mean continuous movement of the object. As used herein stepping of an object is intended to mean movement of the object in a plurality of successive (temporally separated) steps.

The metrology tool 100 may comprise a scatterometer. The object may be a substrate W, for example a resist-coated silicon wafer. Such a substrate W may comprise a plurality of structures (also referred to as targets) that it may be desired to measure. The one or more parameters may comprise one or more of the following: the overlay of two misaligned gratings or periodic structures on the object; and/or a reconstructed structure or profile giving rise to a determined scattering spectrum.

When performing lithographic processes it is desirable to make frequent measurements of the structures created, for example, for process control and verification. Tools to make such measurements are typically called metrology tools. Many existing metrology tools involve the measurement of a plurality of images (each one, for example, comprising a plurality of doses of radiation) captured with a camera. For example, some metrology tools make overlay measurements, which exploit the fact that the diffraction efficiencies of periodic structures are dependent on the unit cell of the periodic structure (and, therefore, any asymmetry of the unit cell). The response of such measurements is sensitive to the wavelength of radiation used by the scatterometer. Furthermore, it is desirable to separate out any imbalance in the relative intensities of certain diffraction orders that is due to overlay errors and other sources of such imbalances. For this reason, these scatterometry metrology tools often make a plurality of separate, sequential measurements of images with different wavelengths of radiation, which are then combined. The specific wavelengths (and bandwidths) are typically dependent on the specific lithographic process or recipe and are typically optimized for a given process so as to maximize the response to overlay errors.

It will be appreciated that as used herein a dose of radiation is intended to mean a quantity of energy received from the radiation. It will also be appreciated that, in general, a dose of energy received by a detector element from radiation may be a time integral of the power of the radiation during a measurement time. If a detector array having a given dynamic range measures two or more different radiation beams having different powers, the smaller power radiation beam may be measured for a larger measurement time and the larger power radiation beam may be measured for a smaller measurement time.

In one type of metrology tool, a broadband radiation source is used and from this a plurality of different wavelengths are selected. The initial source intensity, optical transmission and camera quantum efficiency of each of the plurality of different wavelengths can vary significantly. In order for all of the different wavelengths to be measured by a single detector array, in the dynamic range of the camera, typically a different exposure time is used for each different wavelength. However, it has been found that for some wavelengths, the required exposure times can be so short (for example < 1 ms) that they can give rise to reproducibility issues. At present, for such wavelengths, a neutral density filter is used to attenuate the input illumination of such wavelengths in order to increase the exposure times to reasonable levels (for example > 1 ms). However, the same neutral density filter would penalize the other wavelengths with lower brightness and/or efficiency. This would potentially make the exposure times for these other wavelengths impractically long, significantly decreasing throughput. Therefore, in order to maintain reasonable throughput of the metrology tool, the neutral density filter may need to be moved into and out of the beam path, when switching between wavelengths, which also consumes a significant time (of the order of seconds). It is therefore not practical to perform this switch between each two sequential targets on the substrate (wafer). As a result, the substrate (wafer) is sometimes measured twice (or more if necessary): a first time using one wavelength and a neutral density filter and a second time using another wavelength and no filter.

The new metrology tool 100 shown in Figure 6 is advantageous, as now discussed.

Advantageously, since the controller 140 is configurable such that each dose of scattered radiation of the at least one determined image comprises a total dose of radiation received by a corresponding detector element 132 in a plurality of discrete time intervals during a measurement time interval, which is read out from the corresponding detector element 132 at the end of the measurement time interval, the metrology tool 100 effectively uses the detector array 130 to attenuate the radiation 122 for that determined dose. Effectively, the metrology tool 100 is operable to use a technique that may be referred to as multiple exposure in one frame. Advantageously, with such an interleaved exposure, the sampling at a plurality of discrete time intervals results in a better averaging performance over system-induced dynamic effects (such as, for example, vibrations, mechanical resonances and so on within the metrology tool). An alternative to using the detector array 130 to effectively attenuate the radiation would be to modulate the output of the radiation source 150. A second advantage of using the detector array 130 to effectively attenuate the radiation 122 is to prevent any wavelength change that might arise from such modulation of the output of the radiation source 150.

Note that, as explained above, the controller 140 is effectively operable to use a technique that may be referred to as multiple exposure in one frame. With such a technique, a single image is read out from the detector array 130 once for the at least one determined image. This is different from determining a plurality of images that are subsequently combined (which may be referred to simply as multiple exposure). That is, the new metrology tool 100 does not determine a plurality of images that are read out from the detector array and stored (for example temporarily) and then subsequently combined. Rather, the at least one determined image determined by the metrology tool 100 is a single image, which is read out by each detector element 132 at the end of the measurement time interval. That is, this image is read out once. This is significant as the process of reading out a detector array (for example a plurality of detector elements or pixels in a CMOS array) takes a significant amount of time. Therefore, the use of multiple exposure in one frame (with one read out process at the end of the measurement time interval) can be significantly quicker than multiple exposure processes (where each dose or sub-dose is read out individually).

The detector array 140 may comprise an active-pixel sensor. In some embodiments the detector array 142 may comprise a CMOS (complementary metal-oxide-semiconductor) sensor. That is, in some embodiments, each detector element 142 may comprise a pixel of a CMOS (complementary metal-oxide-semiconductor) sensor pixel.

An example architecture for each of the plurality of detector elements 132 of the detector array 130 is now discussed with reference to Figure 7. Figure 7 shows a circuit diagram for a detector element 200, which may be used for each of the detector elements 132 of the detector array 130 shown in Figure 6.

The detector element 200 comprises: a photosensitive element 210; and a plurality of switches 220, 230, 240, 250. The photosensitive element 210 and the plurality of switches 220, 230, 240, 250 are arranged such that: (a) during each of the plurality of discrete time intervals of that detector element 200, an amount of charge at a first node 260 of the detector element 200 is changed by an amount that is dependent on an amount of radiation received by the photosensitive element 210; (b) at the end of each of the plurality of discrete time intervals an amount of charge that is dependent on an amount of radiation received by the photosensitive element 210 during that discrete time interval is transferred from the first node 260 to a second node 270; and (c) at the end of the measurement time interval a signal indicative of the accumulated charge at the second node 270 is output by the detector element 200. Such an arrangement is particularly suitable for determining a dose that comprises a total dose of radiation received by each of the detector elements in a plurality of discrete time intervals during a measurement time interval. This functionality is now discussed further.

The photosensitive element 210 comprises a photodiode. The photosensitive element 210 is connected between the first node 260 and earth. The plurality of switches comprises a first reset switch 220. The first node 260 is disposed between a cathode of the photodiode 210 and the first reset switch 220. In use, the controller 140 is configured to control the first reset switch 220 at the start of each of the plurality of discrete time intervals so as provide a first bias or voltage V₁ to the first node 260. The anode of the photodiode 210 is connected to earth.

In this embodiment, the first reset switch 220 comprises a transistor. The source of the transistor 220 is connected to a first voltage V₁. The drain of the transistor 210 is connected to the first node 260. The controller may be operable to open and close the first reset switch 220 by applying a signal to the gate 222 of the transistor 220. Opening the switch in this way may reverse bias the photodiode 210 to the first voltage V₁.

The detector element 200 further comprises a capacitor 280 connected between the second node 270 and earth. The plurality of switches comprises a second reset switch 230. The second node 270 is disposed between the capacitor 280 and the second reset switch 230. In use, the controller 140 is configured to control the second reset switch 230 at the start of the measurement time interval so as provide a second bias or voltage V₂ to the second node 270.

In this example, the second reset switch 230 comprises a transistor. The source of the transistor 230 is connected to a second voltage V₂. The drain of the transistor 230 is connected to the second node 270. The controller 140 may be operable to open and close the second reset switch 230 by applying a signal to the gate 232 of the transistor 230. Opening the second reset switch 230 in this way may bias one terminal of the capacitor 280 to the second voltage V₂.

The plurality of switches comprises a transfer switch 240 disposed between the first node 260 and the second node 270. In use, the controller is configured to control the transfer switch 240 at the end of each of the plurality of discrete time intervals so as to transfer the amount of charge that is dependent on an amount of radiation received by the photosensitive element 210 during that discrete time interval from the first node 260 to the second node 270.

In this example embodiment, the transfer switch 240 comprises a transistor. The source and drain of the transistor 240 may be connected to the first and second nodes 260, 270. The controller 40 may be operable to open and close the transfer switch 240 by applying a signal to the gate 242 of the transistor.

When the transfer switch 240 is open charge will be transferred from the first node 260 to the second node 270 such that the two nodes 260, 270 reach the same potential or voltage. The capacitor 280 may have a larger capacitance, for example a significantly larger capacitance, than the photodiode 210. Therefore, when the transfer switch 240 is open (and the first and second nodes 260, 270 reach the same voltage) there will be a larger accumulation of charge at the second node 270.

The plurality of switches further comprises a read-out switch 250. In use, the controller 140 is configured to control the read-out switch 250 at the end of the measurement time interval so as to output the signal 254 indicative of the accumulated charge at the second node 270.

In this embodiment the read-out switch 250 is a transistor. The source of the transistor 250 is (indirectly) connectable to the second node 270 (via an amplifier 290). The source of the transistor 250 is connected to an output node or line 254. The controller 140 may be operable to open and close the transfer switch 250 by applying a signal to the gate 252 of the transistor 250. The read-out switch 250 may alternatively be referred to as a row select switch. In use, the controller 140 may be operable to use the read-out switch 250 to sequentially connect the second node 270 of a plurality of detector elements 132 from different rows of the detector array 130 to an output or column line.

The detector element 200 further comprises an amplifier 290 arranged to amplify the output signal. The amplifier 290 is disposed between the second node 270 and the read-out switch 250. In this example, the amplifier 290 comprises a transistor. The transistor 290 is used as a source follower (also known as common-drain). The source of the transistor may be connected to a reference voltage V₃. The gate of the transistor 290 is connected to the second node 270. The source of the transistor 290 is connected to the read-out switch 250.

It will be appreciated that the controller 140 is operable to send control signals 142 to the detector array 130.

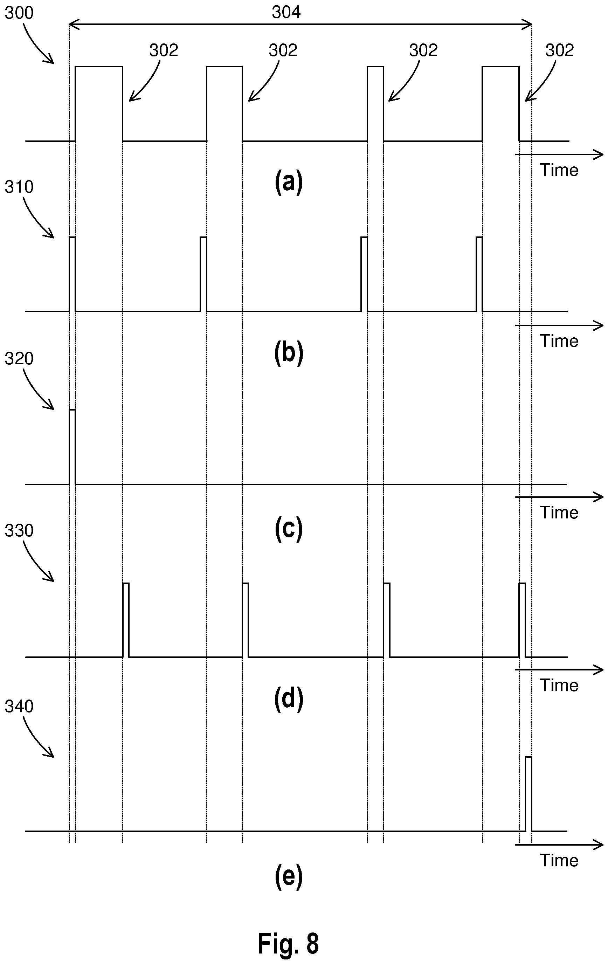

It will be further appreciated that the controller 140 may be operable to send control signals to each of the gates 222, 232, 242, 252 of each of the first reset switch 220, the second reset switch 230, the transfer switch 240 and the read-out switch 250. This may be how the controller 140 is operable to control the detector array 130 such that each dose of scattered radiation used to form a pixel of at least one image comprises a total dose of radiation received by a corresponding one of the plurality of detector elements 132 in a plurality of discrete time intervals during a measurement time interval, which is read out from the corresponding detector element 132 at the end of the measurement time interval. This is now discussed further below with reference to Figure 8.

Figure 8(a) shows an example pulse train 300 that is representative of a temporal sampling by one of the detector elements 200 shown in Figure 7. The pulse train 300 comprises a plurality of pulses 302, each of which represents one of a plurality of discrete time intervals during a measurement time interval 304.

Figure 8(b) shows an example control signal 310 that may be provided by the controller 140 to the gate 222 of the first reset switch 220. The control signal 310 comprises a plurality of pulses, which represent times during which the first reset switch 220 is open. In between the pulses the first reset switch 220 is closed. The time scales of the control signal 310 and the pulse train 300 are equal and aligned.

The control signal 310 for the gate 222 of the first reset switch 220 is configured to control the first reset switch 220 to open and close at the start of each of the plurality of discrete time intervals 302. This provides the first voltage V₁ to the first node 260 and effectively resets the photodiode 210 ready for the start of each of the plurality of discrete time intervals 302.

Figure 8(c) shows an example control signal 320 that may be provided by the controller 140 to the gate 232 of the second reset switch 230. The control signal 320 comprises a single pulse, which represents a time during which the second reset switch 230 is open. At other times, the second reset switch 230 is closed. The time scales of the control signal 320 and the pulse train 300 are equal and aligned.

The control signal 320 for the gate 232 of the second reset switch 230 is configured to control the second reset switch 230 to open and close at the start of the measurement time interval 304. This provides the first voltage V₂ to the second node 270 and effectively resets the capacitor 280 ready for the start of the measurement time interval 304.

Figure 8(d) shows an example control signal 330 that may be provided by the controller 140 to the gate 242 of the transfer switch 240. The control signal 330 comprises a plurality of pulses, which represents times during which the transfer switch 240 is open. At other times, the transfer switch 240 is closed. The time scales of the control signal 330 and the pulse train 300 are equal and aligned.

The control signal 330 for the gate 242 of the transfer switch 240 is configured to control the transfer switch 240 to open and close at the end of each of the plurality of discrete time intervals 302. This transfers a quantity of charge from the first node 260 to the second node 270.

Figure 8(e) shows an example control signal 340 that may be provided by the controller 140 to the gate 252 of the read-out switch 250. The control signal 340 comprises a single pulse, which represents a time during which the read-out switch 250 is open. At other times, the read-out switch 250 is closed. The time scales of the control signal 340 and the pulse train 300 are equal and aligned.

The control signal 340 for the gate 252 of the read-out switch 250 is configured to control the read-out switch 250 to open and close at the end of the measurement time interval 304. The amplifier 290 will be "open" for flow between its source and drain by an amount that is dependent on the total accumulated charge on the second node 170.

It will be appreciated that the detector array 130 may comprise a two-dimensional array of detector elements 132 and these may be read out in a known manner. For example, row by row the detector array 130 may make a measurement, for example by applying signals 310, 320, 330, 340 of the type shown in Figure 8 to the gates 222, 232, 242, 252 of each of the first reset switch 220, the second reset switch 230, the transfer switch 240 and the read-out switch 250. When the read-out switch 250 is open the signal is output to suitable electronics to determine a value based on a current or voltage on the output node or line 254. Once the first row has been measured, the next row is measured and so on. Therefore, the measurement time intervals for two detector elements 132 the same row may be concurrent whereas the measurement time intervals for two detector elements 132 from different rows may be nonconcurrent.

In some embodiments, the plurality of discrete time intervals are not equally spaced within the measurement time interval (as is the case in the example shown in Figure 8). In some embodiments, the plurality of discrete time intervals are not all of equal duration (as is the case in the example shown in Figure 8).

There may be significant advantage to such embodiments wherein the plurality of discrete time intervals the have uneven temporal spacings and/or durations. Recall that one advantage of the sampling obtained by the measurement(s) over a plurality of discrete time intervals is that this results in a better averaging performance over system-induced dynamic effects (such as, for example, vibrations, mechanical resonances and so on within the metrology tool). However, if the sampling achieved over the plurality of discrete time intervals is periodic and happens to have a frequency at, or close to, a frequency of a significant component of the system-induced dynamic effects then no, or little, averaging of those components will be achieved. In contrast, by using a plurality of discrete time intervals the having uneven temporal spacings and/or durations, in general, a better averaging of the system-induced dynamic effects will be achieved.

In some embodiments, the plurality of discrete time intervals may be randomly or quasi-randomly spaced and/or may have random or quasi-random durations.

In some embodiments, a total integrated duration of the plurality of discrete time intervals is less than the measurement time interval by at least a factor of 5. With such embodiments, the detector array 130 is operable, under the control of the controller 140, to achieve an effective attenuation of the radiation by at least a factor of 5.

In some embodiments, the total integrated duration of the plurality of discrete time intervals may be less than the measurement time interval by at least a factor of 10. In some embodiments, the total integrated duration of the plurality of discrete time intervals may be less than the measurement time interval by at least a factor of 20.

In some embodiments, the measurement time interval may be 1 ms or more.

In some embodiments, when determining an image wherein the detector array 130 is being used to effectively attenuate the received radiation as described above, the controller 140 may be operable to send a control signal 142 to the detector array 130 and the number of and/or the length of the plurality of discrete time intervals is dependent on the control signal. The control signal 142 may be used to control the detector array 130. For example, the control signal 142 may comprise a pulse train 300, each pulse 302 corresponding to a different one of the plurality of discrete time intervals. As explained above with reference to Figure 8, the detector array 130 may be controlled by a plurality of control signals (for example signals 310, 320, 330, 340 of the type shown in Figure 8). Therefore, this control signal 142 may comprise this plurality of control signals. Additionally or alternatively, the control signal 142 may comprise a pulse train 300, each pulse 302 corresponding to a different one of the plurality of discrete time intervals, and the detector array 130 may be operable to generate this plurality of control signals from the pulse train 300.

In some embodiments, the controller 140 may be operable to generate the control signal 142. For example, for embodiments wherein the plurality of discrete time intervals have uneven temporal spacings and/or unequal durations, the controller 140 may be operable to generate a pulse train 300. For example, the controller 140 may comprise, or have access to, a random or quasi-random number generator.

In some embodiments, the controller 140 is operable to generate the control signal 142 so as to achieve a target ratio of a total integrated duration of the plurality of discrete time intervals to the measurement time interval. That is, the controller 140 is operable to generate the control signal 142 so as to achieve a target attenuation factor.

In some embodiments, the controller 140 is operable to generate the control signal 142 in dependence on: (a) a power of the radiation 122 that contributes to that image; (b) a dynamic range of the detector elements 132 measuring the plurality of doses; and (c) a measurement time interval threshold. It will be appreciated that the target attenuation factor will, in general, be dependent on: (a) the power of the radiation 122 that contributes to that image; (b) the dynamic range of the detector elements 132 measuring the plurality of dose (which the image comprises); and (c) a measurement time interval threshold. Furthermore, in turn, the measurement time interval threshold may be dependent on a characteristic time scale of the system-induced dynamic effects. The power of the radiation 122 that contributes to that image may be known or measured. The dynamic range of the detector elements 132 measuring the image may be known. The measurement time interval threshold may be sufficiently large that a measurement over such a time period would average out such system-induced dynamic effects. The measurement time interval threshold may, for example, be of the order of 1 ms.

For example, from the power of the radiation 122 that contributes to that image and the dynamic range of the detector array measuring the image, a target sampling time may be generated that ensures that the doses of radiation received by the detector elements 132 are within the dynamic range of the detector elements 132. If the target sampling time is above the measurement time interval threshold then the detector array 130 may be not used for attenuation of the radiation 122. In contrast, if the target sampling time is below the measurement time interval threshold then a target attenuation factor may be determined. The target attenuation factor may be determined to be equal to or greater than a ratio of the measurement time interval threshold to the target sampling time.

In some embodiments, the controller 140 is operable to control the detector array 130 so as to determine at least two images, each such at least two images comprising a plurality of doses of scattered radiation; and determine the one or more parameters of interest in dependence on the at least two determined images.

In some embodiments, each dose of scattered radiation of at least one of the at least two images comprises a total dose of radiation received by a corresponding one of the plurality of detector elements 132 in a plurality of discrete time intervals during a measurement time interval, which is read out from the corresponding detector element 132 at the end of the measurement time interval; and each dose of scattered radiation 122 of at least one of the at least two images comprises a dose of radiation received during a continuous measurement time interval, which is read out from the corresponding detector element at the end of the measurement time interval. Advantageously, such embodiments use the detector array 130, controlled by the controller 140, to effectively attenuate one dose while the other dose is not attenuated.

Alternatively, in some other embodiments, each dose of scattered radiation of at least two of the at least two images comprises a total dose of radiation received by a corresponding one of the plurality of detector elements 132 of the detector array 130 in a plurality of discrete time intervals during a measurement time interval, which is read out from the corresponding detector element 132 at the end of the measurement time interval but a ratio of the total integrated duration of the plurality of discrete time intervals to the measurement time interval is different for the at least two images. Such embodiments use the detector array, controlled by the controller, to effectively attenuate the radiation used for forming the at least two images by different amounts.

In some embodiments, at least two images are determined sequentially by projecting different radiation onto the structure (on the substrate W). Each of the two images may be determined using scattered radiation having different wavelengths.

In some embodiments, two images which are determined at substantially the same time by projecting a single radiation beam 112 onto the structure may be attenuated by different amounts. It will be appreciated that as used here, two images being determined at substantially the same time is intended to mean that there is at least some temporal overlap between the two measurements.

In some embodiments, two images which are attenuated by different amounts may be determined using different sets of the plurality of detecting elements 132 of the detector array 130. The plurality of discrete time intervals may have any temporal spacings and/or durations as desired or required. For example, the plurality of discrete time intervals could be periodic and may have equal durations.

Some embodiments of the present disclosure relate to new metrology methods for determining one or more parameters of interest of a structure on an object (e.g. a wafer). In particular, they relate to new metrology methods that may use a detector array comprising a plurality of detector elements (pixels) wherein the detector array is arranged to provide fast, controllable attenuation to radiation received by it in order to ensure that both: (a) the amount of radiation used to form an image is within the dynamic range of the detector array; and (b) the measurement time period over which the image is captured is not undesirably short.

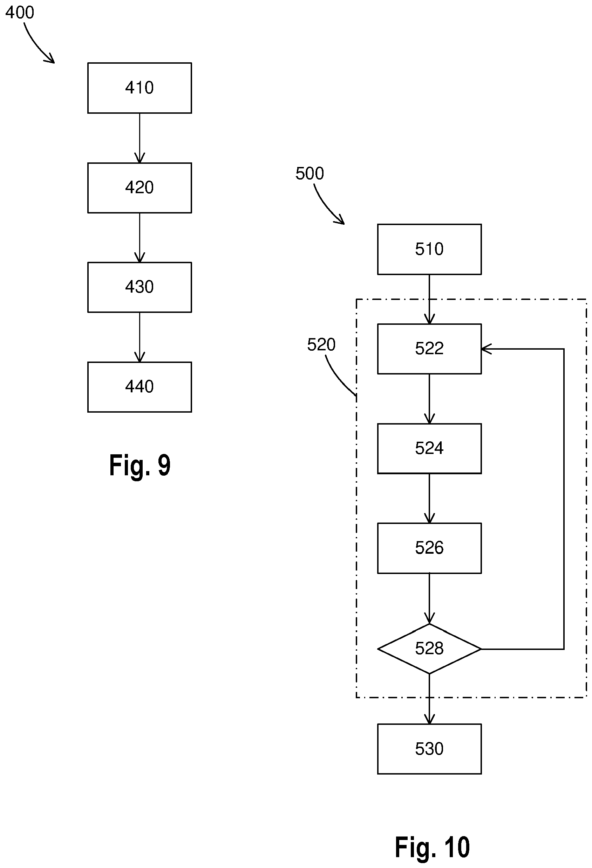

It will be appreciated that these new metrology methods may be carried out using the new metrology tool described above with reference to Figures 6 to 8. An example of such a new metrology method 400 is now described with reference to Figures 9 and 10.

The metrology method 400 comprises a step 410 of projecting radiation 112 onto the structure and a step 420 of receiving at least a portion of the radiation 122 scattered by the structure.

The metrology method 400 further comprises a step 430 of determining at least one image (each such at least one image comprising a plurality of doses of scattered radiation 122) and a step 440 of determining one or more parameters of interest from the at least one determined image. In particular, each dose of scattered radiation of at least one image determined at step 430 comprises a total dose of radiation received by a corresponding detector element 132 in a plurality of discrete time intervals during a measurement time interval, which is read out from the corresponding detector element 132 at the end of the measurement time interval.

Advantageously, since each dose of scattered radiation (i.e. pixel) of at least one image determined at step 430 comprises a total dose of radiation received by the corresponding detector element 132 in a plurality of discrete time intervals during a measurement time interval, which is read out by the corresponding detector element 132 at the end of the measurement time interval, the new metrology method 400 effectively uses a detector array 130 to attenuate the radiation 122 for that image. Effectively, the new metrology method 400 is operable to use a technique that may be referred to as multiple exposure in one frame. Advantageously, with such an interleaved exposure, the sampling at a plurality of discrete time intervals results in a better averaging performance over system-induced dynamic effects (such as, for example, vibrations, mechanical resonances and so on within the metrology tool). A second advantage of using a detector 140 to effectively attenuate the radiation 122 is to prevent any wavelength change that might arise from modulating a radiation source 150.

The method 400 shown in Figure 9 may comprise any combination of the features of the metrology tool 100 described above with reference to Figures 6 to 8 as appropriate.

Determining (at step 430) each dose of scattered radiation (i.e. each pixel) of the at least one determined images that is so attenuated comprises the following sub-steps. First, it comprises a sub-step of changing a charge at a first node 260 of the detector element 132, 200 during each of the plurality of discrete time intervals of that detector element 132, 200 by an amount that is dependent on an amount of radiation received by the detector element 200. Second, it comprises a sub-step of: at the end of each of the plurality of discrete time intervals transferring an amount of charge that is dependent on an amount of radiation received by the detector element 132, 200 during that discrete time interval from the first node 260 to a second node 270. Third, it comprises a sub-step of: at the end of the measurement time interval outputting a signal 254 indicative of the accumulated charge at the second node 270.

With such an arrangement, the information about the amount of radiation received during the plurality of discrete time intervals during a measurement time interval is effectively buffered and stored locally on the detector element (pixel) 132, 200 as an amount of charge. Advantageously, this is significantly quicker than reading out a signal indicative of the amount of radiation received during each of the plurality of discrete time intervals, storing this (e.g. in memory) and then combining these amounts to determine the total dose. This is partially due the large amount of time required to read out the plurality of detector elements (pixels) 132, 200 of a detector array 130.

An example flow chart 500 for determining (at step 430) each dose of scattered radiation (i.e. each pixel) of the at least one determined images that is attenuated by the detector array 130 is shown in Figure 10.

First, at step 510, at the start of the measurement time interval the second node 270 of the detector element 132, 200 is set to a second bias or voltage V₂.

Next, a loop 520 is performed n times, once for each of the plurality of discrete time intervals.

The loop 520 comprises a step 522 of: at the start of each of the plurality of discrete time intervals setting the first node to a first bias or voltage V₁.

The loop 520 further comprises a step 524 of: changing a charge at a first node 260 of the detector element 132, 200 during each of the plurality of discrete time intervals of that detector element 132, 200 by an amount that is dependent on an amount of radiation received by the detector element 132, 200.

The loop 520 further comprises a step 526 of: at the end of each of the plurality of discrete time intervals transferring an amount of charge that is dependent on an amount of radiation received by the detector element 132, 200 during that discrete time interval from the first node 260 to a second node 270.

At step 528 of the loop, if all of the plurality of discrete time intervals have elapsed, the flowchart 500 progresses to step 530 and, if not, the flowchart returns to step 522 for the next discrete time period measurement.

At step 530, at the end of the measurement time interval, a signal 254 indicative of the accumulated charge at the second node 270 is output.

Further embodiments have been disclosed in the following numbered list of clauses:
1. A metrology tool for determining one or more parameters of interest of a structure on an object, the metrology tool comprising:
   projection optics arranged to project radiation onto the structure;
   detection optics arranged to receive at least a portion of radiation scattered by the structure;
   a detector array comprising a plurality of detector elements, each of the plurality of detector elements being operable to determine a dose of received scattered radiation; and
   a controller operable to:
      control the detector array so as to determine at least one image, each such at least one image comprising a plurality of doses of scattered radiation, each determined by a different one of the plurality of detector elements; and
      determine one or more parameters of interest in dependence on the at least one determined image; and
   wherein the controller is configurable such that each dose of scattered radiation of at least one of the at least one determined image comprises a total dose of radiation received by a corresponding one of the plurality of detector element in a plurality of discrete time intervals during a measurement time interval, which is read out from the corresponding detector element at the end of the measurement time interval.
2. The metrology tool of clause 1 wherein the each of the plurality of detector elements comprises:
   a photosensitive element; and
   a plurality of switches;
   arranged such that:
      during each of the plurality of discrete time intervals of that detector element, an amount of charge at a first node of the detector element is changed by an amount that is dependent on an amount of radiation received by the photosensitive element;
      at the end of each of the plurality of discrete time intervals an amount of charge that is dependent on an amount of radiation received by the photosensitive element during that discrete time interval is transferred from the first node to a second node; and
      at the end of the measurement time interval a signal indicative of the accumulated charge at the second node is output by the detector element.
3. The metrology tool of clause 2 wherein the plurality of switches comprises a first reset switch, the first node being disposed between a cathode of the photosensitive element and the first reset switch; and wherein the controller is configured to control the first reset switch at the start of each of the plurality of discrete time intervals so as provide a first bias or voltage to the first node.
4. The metrology tool of clause 2 or clause 3, further comprising a capacitor and wherein the plurality of switches comprises a second reset switch, the second node being disposed between the capacitor and the second reset switch; and wherein the controller is configured to control the second reset switch at the start of the measurement time interval so as provide a second bias or voltage to the second node.
5. The metrology tool of any one of clauses 2 to 4 wherein the plurality of switches comprises a transfer switch disposed between the first node and the second node; and wherein the controller is configured to control the transfer switch at the end of each of the plurality of discrete time intervals so as to transfer the amount of charge that is dependent on an amount of radiation received by the photosensitive element during that discrete time interval from the first node to a second node.
6. The metrology tool of any one of clauses 2 to 5 wherein the plurality of switches comprises a read-out switch and wherein the controller is configured to control the read-out switch at the end of the measurement time interval so as to output the signal indicative of the accumulated charge at the second node.
7. The metrology tool of any preceding clause wherein the detector comprises an active-pixel sensor.
8. The metrology tool of any preceding clause wherein when determining the at least one of the at least one determined image the controller is operable to send a control signal to the detector and the number of and/or the length of the plurality of discrete time intervals is dependent on the control signal.
9. The metrology tool of clause 8 wherein the controller is operable to generate the control signal.
10. The metrology tool of clause 9 wherein the controller is operable to generate the control signal so as to achieve a target ratio of a total integrated duration of the plurality of discrete time intervals to the measurement time interval.
11. The metrology tool of clause 9 or clause 10 wherein the controller is operable to generate the control signal in dependence on: (a) a power of the radiation that contributes to that image; (b) a dynamic range of the detector elements measuring the plurality of doses; and (c) a measurement time interval threshold.
12. The metrology tool of any preceding clause wherein the controller is operable to control the detector array so as to determine at least two images, each such at least two images comprising a plurality of doses of scattered radiation; and determine the one or more parameters of interest in dependence on the at least two determined images.
13. The metrology tool of clause 12 wherein the at least two images are determined sequentially by projecting different radiation onto the structure.
14. The metrology tool of clause 12 or clause 13 wherein each of the at least two images are determined using scattered radiation having different wavelengths.
15. The metrology tool of clause 12 wherein the at least two images are determined at substantially the same time by projecting a single radiation beam onto the structure.
16. The metrology tool of clause 12 or clause 15 wherein the at least two images are determined using a different set of the plurality of detecting elements of the detector array.
17. The metrology tool of any preceding clause wherein the plurality of discrete time intervals are not equally spaced within the measurement time interval.
18. The metrology tool of any preceding clause wherein the plurality of discrete time intervals are not all of equal duration.
19. The metrology tool of any preceding clause wherein the plurality of discrete time intervals are randomly or quasi-randomly spaced and/or have random or quasi-random durations.
20. The metrology tool of any preceding clause wherein a total integrated duration of the plurality of discrete time intervals is less than the measurement time interval by at least a factor of 5.
21. The metrology tool of any preceding clause wherein the measurement time interval is 1 ms or more.
22. The metrology tool of any preceding clause further comprising a radiation source operable to produce the radiation.
23. The metrology tool of clause 22 further comprising a radiation adjustment module operable to receive radiation from the radiation source and to output radiation having modified characteristics.
24. The metrology tool of any preceding clause further comprising a support for supporting an object such that it is positionable in an illumination region of the projection optics.
25. The metrology tool of clause 24 further comprising a movement mechanism operable to cause relative movement of the support and the illumination region of the projection optics.
26. A metrology method for determining one or more parameters of interest of a structure on an object, the metrology method comprising:
   projecting radiation onto the structure;
   receiving at least a portion of the radiation scattered by the structure;
   determining at least one image, each such at least one image comprising a plurality of doses of scattered radiation; and
   determining one or more parameters of interest from the at least one determined image;
   wherein each dose of scattered radiation of at least one of the at least one determined images comprises a total dose of radiation received by a corresponding detector element in a plurality of discrete time intervals during a measurement time interval, which is read out from the corresponding detector element at the end of the measurement time interval.
27. The method of clause 26 wherein determining each dose of scattered radiation of the at least one of the at least one determined images comprises:
   changing a charge at a first node of the detector element during each of the plurality of discrete time intervals of that detector element by an amount that is dependent on an amount of radiation received by the detector element;
   at the end of each of the plurality of discrete time intervals transferring an amount of charge that is dependent on an amount of radiation received by the detector element during that discrete time interval from the first node to a second node; and
   at the end of the measurement time interval outputting a signal indicative of the accumulated charge at the second node.
28. The method of clause 27 comprising setting the first node to a first bias or voltage at the start of each of the plurality of discrete time intervals.
29. The method of clause 27 or clause 28 comprising setting the second node to a second bias or voltage at the start of the measurement time interval.
30. The metrology method of any one of clauses 26 to 29 wherein determining the at least one of the at least one determined images comprises sending a control signal to a detector array and wherein the number of and/or the length of the plurality of discrete time intervals is dependent on the control signal.
31. The metrology method of clause 30 further comprising generating the control signal.
32. The metrology method of clause 31 wherein the control signal is generated so as to achieve a target ratio of a total integrated duration of the plurality of discrete time intervals to the measurement time interval.
33. The metrology method of clause 31 or clause 32 wherein the control signal is generated in dependence on: (a) a power of the radiation that contributes to that image; (b) a dynamic range of the detector array measuring the plurality of doses; and (c) a measurement time interval threshold.
34. The metrology method of any one of clauses 26 to 33 comprising determining at least two images, each such at least one image comprising a plurality of doses of scattered radiation, from which one or more parameters of interest are determined.
35. The metrology method of clause 34 wherein the at least two images are determined sequentially by projecting different radiation onto the structure.
36. The metrology method of clause 34 or clause 35 wherein each of the at least two images are determined using radiation having different wavelengths.
37. The metrology method of clause 34 wherein the at least two images are determined at substantially the same time by projecting a single radiation beam onto the structure.
38. The metrology method of clause 34 or clause 37 wherein each of the at least two doses of scattered radiation is determined by a different set of detector elements.
39. The metrology method of any one of clauses 26 to 38 wherein the plurality of discrete time intervals are not equally spaced within the measurement time interval.
40. The metrology method of any one of clauses 26 to 39 wherein the plurality of discrete time intervals are not all of equal duration.
41. The metrology method of any one of clauses 26 to 40 wherein the plurality of discrete time intervals are randomly or quasi-randomly spaced and/or have random or quasi-random durations.
42. The metrology method of any one of clauses 26 to 41 wherein a total integrated duration of the plurality of discrete time intervals is less than the measurement time interval by at least a factor of 5.
43. The metrology method of any one of clauses 26 to 42 wherein the measurement time interval is 1 ms or more.
43. A lithographic tool comprising a metrology tool in accordance with any one of the claims 1 to 25.

Although specific reference is made to "metrology apparatus / tool / system" or "inspection apparatus / tool / system", these terms may refer to the same or similar types of tools, apparatuses or systems. For example, the inspection or metrology apparatus that comprises an embodiment of the invention may be used to determine characteristics of structures on a substrate or on a wafer. For example, the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A metrology tool for determining one or more parameters of interest of a structure on an object, the metrology tool comprising:
projection optics arranged to project radiation onto the structure;
detection optics arranged to receive at least a portion of radiation scattered by the structure;
a detector array comprising a plurality of detector elements, each of the plurality of detector elements being operable to determine a dose of received scattered radiation; and
a controller operable to:
control the detector array so as to determine at least one image, each such at least one image comprising a plurality of doses of scattered radiation, each determined by a different one of the plurality of detector elements; and
determine one or more parameters of interest in dependence on the at least one determined image; and
wherein the controller is configurable such that each dose of scattered radiation of at least one of the at least one determined image comprises a total dose of radiation received by a corresponding one of the plurality of detector element in a plurality of discrete time intervals during a measurement time interval, which is read out from the corresponding detector element at the end of the measurement time interval.

2. The metrology tool of any preceding claim wherein when determining the at least one of the at least one determined image the controller is operable to send a control signal to the detector and the number of and/or the length of the plurality of discrete time intervals is dependent on the control signal.

3. The metrology tool of claim 2 wherein the controller is operable to generate the control signal so as to achieve a target ratio of a total integrated duration of the plurality of discrete time intervals to the measurement time interval.

4. The metrology tool of claim 2 or 3 wherein the controller is operable to generate the control signal in dependence on: (a) a power of the radiation that contributes to that image; (b) a dynamic range of the detector elements measuring the plurality of doses; and (c) a measurement time interval threshold.

5. The metrology tool of any preceding claim wherein the controller is operable to control the detector array so as to determine at least two images, each such at least two images comprising a plurality of doses of scattered radiation; and determine the one or more parameters of interest in dependence on the at least two determined images.

6. The metrology tool of any preceding claim wherein the plurality of discrete time intervals are not equally spaced within the measurement time interval.

7. The metrology tool of any preceding claim wherein the plurality of discrete time intervals are not all of equal duration.

8. The metrology tool of any preceding claim wherein the plurality of discrete time intervals are randomly or quasi-randomly spaced and/or have random or quasi-random durations.

9. The metrology tool of any preceding claim wherein a total integrated duration of the plurality of discrete time intervals is less than the measurement time interval by at least a factor of 5.

10. The metrology tool of any preceding claim wherein the measurement time interval is 1 ms or more.

11. The metrology tool of any preceding claim further comprising a radiation source operable to produce the radiation.

12. The metrology tool of any preceding claim wherein the each of the plurality of detector elements comprises:
a photosensitive element; and
a plurality of switches;
arranged such that:
during each of the plurality of discrete time intervals of that detector element, an amount of charge at a first node of the detector element is changed by an amount that is dependent on an amount of radiation received by the photosensitive element;
at the end of each of the plurality of discrete time intervals an amount of charge that is dependent on an amount of radiation received by the photosensitive element during that discrete time interval is transferred from the first node to a second node; and
at the end of the measurement time interval a signal indicative of the accumulated charge at the second node is output by the detector element.

13. The metrology tool of claim 12, wherein the plurality of switches comprises a first reset switch, the first node being disposed between a cathode of the photosensitive element and the first reset switch; and wherein the controller is configured to control the first reset switch at the start of each of the plurality of discrete time intervals so as provide a first bias or voltage to the first node.

14. The metrology tool of claim 12 or 13, further comprising a capacitor and wherein the plurality of switches comprises a second reset switch, the second node being disposed between the capacitor and the second reset switch; and wherein the controller is configured to control the second reset switch at the start of the measurement time interval so as provide a second bias or voltage to the second node.

15. A metrology method for determining one or more parameters of interest of a structure on an object, the metrology method comprising:
projecting radiation onto the structure;
receiving at least a portion of the radiation scattered by the structure;
determining at least one image, each such at least one image comprising a plurality of doses of scattered radiation; and
determining one or more parameters of interest from the at least one determined image;
wherein each dose of scattered radiation of at least one of the at least one determined images comprises a total dose of radiation received by a corresponding detector element in a plurality of discrete time intervals during a measurement time interval, which is read out from the corresponding detector element at the end of the measurement time interval.
